# EUROPEAN PATENT APPLICATION

(11) **EP 2 164 098 A1**
(43) Date of publication of application: **17.03.2010**
(21) Application number: 08790715.0
(22) Date of filing: 27.06.2008
(51) Int. Cl.: H01L 23/02, H01L 23/12, H01L 27/14, H04N 5/335

(54) **SEMICONDUCTOR PACKAGE AND METHOD FOR MANUFACTURING THE SAME**

(30) Priority: 29.06.2007 JP 2007171915
(71) Applicant: Fujikura, Ltd., Tokyo 135-8512 (JP)
(72) Inventor: SUTO, Yuki, Sakura-shi Chiba 285-8550 (JP)
(74) Representative: Cabinet Plasseraud
(86) International application number: PCT/JP2008/061773
(87) International publication number: WO 2009/005017

(57) **Abstract**

To provide a semiconductor package provided with a semiconductor device; a semiconductor substrate having the semiconductor device arranged on one surface; a cap substrate having one surface that opposes the one surface of the semiconductor substrate via a gap; a spacer that is arranged between the one surface of the semiconductor substrate and the one surface of the cap substrate, and that joins the semiconductor substrate and the cap substrate; and a filter that is provided on the cap substrate so as to overlap with the semiconductor device without overlapping with the spacer. According to the present invention, it is possible to provide a semiconductor package that can suppress exfoliation of the filter by chipping during the dicing step, and a method of manufacturing the semiconductor package.

## Description

### TECHNICAL FIELD

The present invention relates to a semiconductor package and a manufacturing method thereof, and more specifically, to a countermeasure against exfoliation of a filter that is disposed in the semiconductor package.

Priority is claimed on Japanese Patent Application No. 2007-171915, filed June 29, 2007, the content of which is incorporated herein by reference.

### BACKGROUND ART

For recent mobile phones and mobile information terminals, and mobile electronic devices such as digital cameras, their portability and weight saving are major market needs. For that reason, further reductions in the size and thickness of chips such as semiconductor integrated circuits that mounted therein are essential, and a stable manufacturing process is called for.

In optical semiconductor devices that are represented by CCDs and CMOSs that are mounted in these mobile electronic devices, optical filters, such as an infrared cut-off filter, are used. When applying these optical filters to a wafer level package of an optical semiconductor, package processing may be performed that consists of forming an optical filter on a glass substrate.

As procedures of forming a filter on a conventional glass substrate, there is a method that forms a filter on a glass substrate after the completion of package processing, and there is a method that first forms a filter on a glass substrate and then performs package processing. In the case of forming a filter in the interior of a package in order to protect the filter, the latter method is adopted. Also, although the former involves separately forming a filter in each package, that latter has the advantage of being able to form a filter at the wafer level at once.

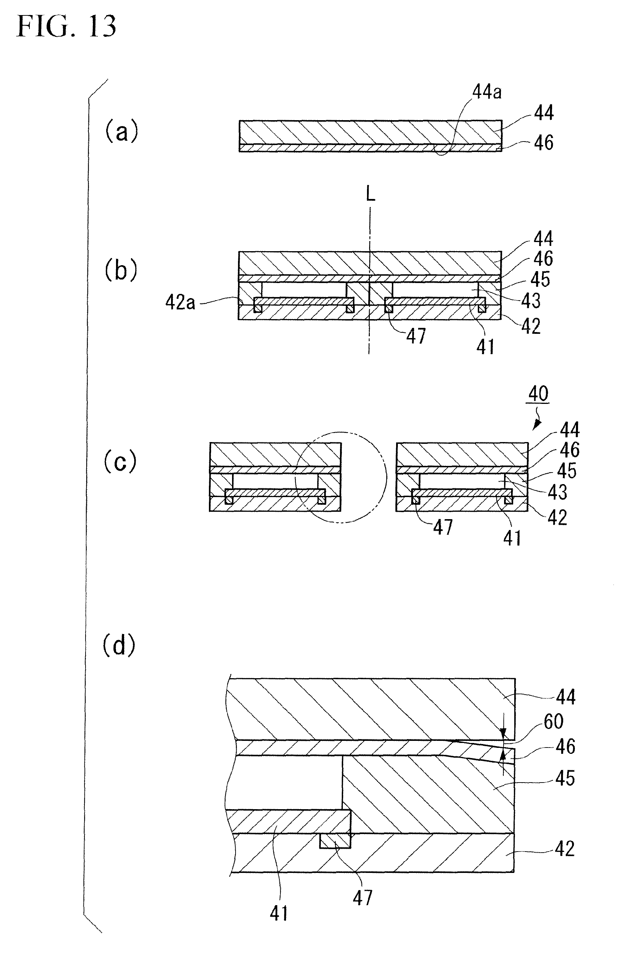

FIG. 13 is a cross-sectional view of a manufacturing process for a conventional semiconductor package in which a filter is formed in a package. In the manufacturing process for this semiconductor package 40, as shown in (a) of FIG. 13, the filter 46 is disposed on a surface 44a of a cap substrate 44. Next, the filter 46 and a semiconductor substrate 42 are joined via a spacer 45. Next, as shown in (b) of FIG. 13, dicing of the semiconductor wafer is carried out at the location shown by the dashed line L. In the chipping due to this dicing, there is the possibility of exfoliation of this filter 46 occurring as shown in (d) of FIG. 13. This exfoliation 60 of the filter 46 is magnified in a reliability test and the like, and at times it has caused the semiconductor package 40 to malfunction. Also, since the spacer 45 is directly adhered to the filter 46, when the adhesion between of the filter 46 and the cap substrate 44 is weak, there is the possibility of the filter 46 exfoliating under the stress arising from expansion and contraction of the spacer 45.

The present invention was achieved in view of the above circumstances, and has as its first object to provide a semiconductor package that is capable of suppressing exfoliation of a filter due to chipping in the dicing process. Also, the present invention has as its second object to provide a method of manufacturing a semiconductor package that is capable of suppressing exfoliation of a filter in the dicing process.

### DISCLOSURE OF THE INVENTION

A first aspect of the semiconductor package of the present invention is a semiconductor package that includes a semiconductor substrate having a semiconductor device disposed on one surface thereof, a cap substrate having one surface arranged opposite to the semiconductor substrate via a gap from the one surface of the semiconductor substrate, with the one surface provided with a flat portion over the entire area or a regional projecting portion along with the flat portion, and a spacer that is provided in a protruding manner at the flat portion or projecting portion of the one surface of the cap substrate opposite to the semiconductor substrate and that bonds the cap substrate and the semiconductor substrate, being provided with a filter that is disposed on the cap substrate, and the filter being at a position that overlaps with the semiconductor device and not overlapping with the spacer.

In a second aspect of the semiconductor package of the present invention, the filter in the first aspect is disposed overlapping in the order of the semiconductor substrate, the filter, and the cap substrate.

In a third aspect of the semiconductor package of the present invention, the filter in the first aspect is disposed overlapping in the order of the semiconductor substrate, the cap substrate, and the filter.

In a fourth aspect of the semiconductor package of the present invention, the filter in the first aspect has a first filter and a second filter, and being disposed overlapping in the order of the semiconductor substrate, the first filter, the cap substrate, and the second filter.

A fifth aspect of the semiconductor package of the present invention includes an electrode that is on one surface side of the semiconductor substrate and in electrical contact with the semiconductor device, a penetration electrode that is provided from the other surface side of the semiconductor substrate toward the electrode, and a solder bump that is electrically connected with the penetration electrode.

A first aspect of a method of manufacturing a semiconductor package of the present invention is a method of manufacturing a semiconductor package that includes a semiconductor substrate having a semiconductor device disposed on one surface thereof, a cap substrate having one surface arranged opposite to the semiconductor substrate via a gap from the one surface of the semiconductor substrate, with the one surface provided with a flat portion over the entire area or a regional projecting portion along with the flat portion, and a spacer that is provided in a protruding manner at the flat portion or projecting portion of the one surface of the cap substrate opposite to the semiconductor substrate and that bonds the cap substrate and the semiconductor substrate, being provided with a filter that is disposed on the cap substrate, and the filter being at a position that overlaps with the semiconductor device without overlapping with the spacer, the method includes in the following order a first step that forms the filter on the cap substrate, a second step that bonds the semiconductor substrate on one surface of which a plurality of the semiconductor devices are disposed so as to mutually sandwich a dividing portion and the cap substrate on which the filter is disposed via the spacer at the separating portion, and a third step that divides a structure that includes the cap substrate, the semiconductor devices, the semiconductor substrate, and the spacer in the direction in which the semiconductor substrate and the cap substrate overlap at the region where the spacer is.

A second aspect of the method of manufacturing a semiconductor package of the present invention includes, after the second step, a step that forms a penetration electrode to be electrically connected from the other surface side of the semiconductor substrate toward the semiconductor device and a step that forms a solder bump that is electrically connected with the penetration electrode.

### [Effect of the Invention]

In a semiconductor package of the present invention, a cap substrate is arranged via a gap opposite from one surface of a semiconductor substrate in which a semiconductor device is disposed on one surface. A spacer is provided in a protruding manner on a surface of this cap substrate opposite to the semiconductor substrate and bonds the semiconductor substrate and the cap substrate. Also, a filter is disposed on the cap substrate so as to overlap with the semiconductor device, and is at a position that does not overlap with the spacer.

With this constitution, since the division location of the semiconductor package is at a position that divides the spacer into two, it is possible to prevent exfoliation of the filter due to chipping without dividing the filter.

Also, in a method of manufacturing a semiconductor package of the present invention, after forming the filter on the one surface of the cap substrate so as to overlap the semiconductor device, the spacer which is located in a position that does not overlap the filter brings into opposition and bonds the semiconductor substrate on which a plurality of semiconductor devices are disposed by providing a dividing portion and the cap substrate. Thereafter, a structure that is formed by the semiconductor substrate, the cap substrate, and the spacer being bonded is divided at a location that divides the spacer into two. In this manufacturing process, since the filter is not disposed at the place of division of the semiconductor package, in the division step, it is possible to prevent exfoliation of the filter from the cap substrate due to chipping.

### BRIEF DESCRIPTION OF THE DRAWINGS

FIG. 1 is a cross-sectional view of the semiconductor package that shows an example according to a first embodiment of the present invention.
FIG. 2 is a cross-sectional view of a semiconductor package that shows an example according to Example 1 of the present invention.
FIG. 3 is a cross-sectional view of a semiconductor package that shows an example according to a second embodiment of the present invention.
FIG. 4 is a cross-sectional view of a semiconductor package that shows an example according to Example 2 of the present invention.
FIG. 5 is a cross-sectional view of a semiconductor package that shows an example according to a third embodiment of the present invention.
FIG. 6 is a cross-sectional view of a semiconductor package that shows an example according to Example 3 of the present invention.
FIG. 7 is a cross-sectional process drawing of a semiconductor package according to a first embodiment of the present invention.
FIG. 8 is a cross-sectional process drawing of a semiconductor package according to a second embodiment of the present invention.
FIG. 9 is a cross-sectional process drawing of a semiconductor package according to a third embodiment of the present invention.
FIG. 10 is a cross-sectional process drawing of a semiconductor package that is provided with a penetration electrode and a solder bump in the first embodiment of the present invention.
FIG. 11 is a cross-sectional process drawing of the semiconductor package that is provided with a penetration electrode and a solder bump in the second embodiment of the present invention.
FIG. 12 is a cross-sectional process drawing of the semiconductor package that is provided with a penetration electrode and a solder bump in the third embodiment of the present invention.
FIG. 13 is a drawing of a conventional semiconductor package and a cross-sectional process drawing, and a schematic drawing of filter exfoliation.

### [Description of Reference Numerals]

11, 21, 31, 41 semiconductor device
12, 22, 32, 42 semiconductor substrate
13, 23, 33, 43 gap
14, 24, 34, 44 cap substrate
14P, 24P, 34P, 44P cap substrate projecting portion
15, 25, 35, 45 spacer
16, 26, 36, (36a, 36b), 46 filter
17, 27, 37, 47 electrode
18, 28, 38 penetration electrode
19, 29, 39 solder bump
10 (10A, 10B, 10C, 10D) semiconductor package according to first embodiment
20 (20A, 20B, 20C, 20D) semiconductor package according to second embodiment
30 (30A, 30B, 30C, 30D) semiconductor package according to third embodiment
40 conventional semiconductor package
50 protective film
60 exfoliation of filter
L dicing location

### BEST MODE FOR CARRYING OUT THE INVENTION

Hereinbelow, the present invention shall be described with reference to the drawings.

The present invention is not restricted by these embodiments.

### First Embodiment

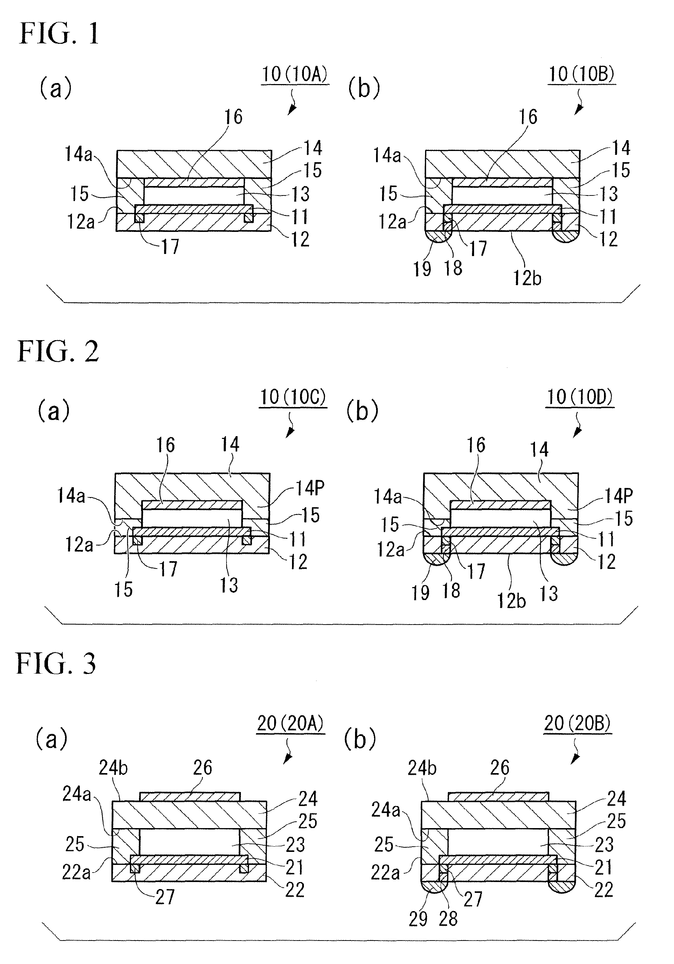

FIG. 1 is a cross-sectional view that shows the first embodiment of the semi-conductor package according to the present invention.

In the semiconductor package 10A, a semiconductor device 11 is disposed on a surface 12a of a semiconductor substrate 12. From this semiconductor substrate 12, a cap substrate 14 is disposed opposite via a gap 13. Also, a spacer 15 is provided in a protruding manner on a surface 14a opposite to the semiconductor substrate 12, and bonds the semiconductor substrate 12 and the cap substrate 14. Furthermore, a filter 16 is disposed on the surface 14a of the cap substrate 14 so as to overlap with the semiconductor device 11 but not to overlap with the spacer 15.

In relation to the semiconductor device 11, an image sensor such as a CCD or CMOS is preferred. Moreover, a MEMS (Micro Electro Mechanical System) device or the like can be used, with examples including a micro relay, a microswitch, a pressure sensor, an acceleration sensor, a high-frequency filter, a micro mirror, and the like.

As the material of the semiconductor substrate 12, for example, gallium arsenide, glass, ceramic, germanium, silicon, and the like are used. Moreover, it is preferable to have an electrode 17 that is in electrical contact with the semiconductor device 11 disposed on the surface 12a of the semiconductor substrate 12. In relation to this electrode 17, provided it is in electrical contact with the semiconductor device 11, it is not particularly limited, but the arrangement location is preferably provided on the surface 12a of the semiconductor substrate. Concerning the material of the electrode 17, Al, Al-Cu, Al-Si-Cu or the like is used. This is used as an I/O pad.

In relation to the gap 13, it is not particularly limited, and can be freely selected corresponding to conditions such as the specification demanded from the semiconductor device 11 or the like, and for example provided it is in the range of several µm to several hundred µm, it is possible to ensure a sufficient cavity in the vicinity of the semiconductor device 11, and it is possible to control the dimensions of the semiconductor package 10.

For example, in the case of the semiconductor device 11 being an image sensor, such as a CCD, a CMOS, or the like, when the distance between the semiconductor substrate 12 and the cap substrate 14 becomes too close, it may be susceptible to particles adhering to the cap substrate 14 and the like, and in such a case, it is possible to utilize to the upmost the role of the gap 13 that is secured between the semiconductor substrate 12 and the cap substrate 14 by the spacer 15.

In relation to the cap substrate 14, it is arranged above the semiconductor device 11 via the gap 13, and has a role of protecting the semiconductor device 11 or the like. As the material of the cap substrate 14, it is possible to use a plate that consists of resin or glass, metal or the like, and in the case of applying to an optical semiconductor device such as a CCD, a CMOS, or the like, it is preferable to use a material such as glass or the like that has light transmittance. Also, it is preferably parallel to and opposite to the semiconductor substrate 12.

In order that the spacer 15 may secure the gap 13 between the semiconductor substrate 12 and the cap substrate 14, when joining the cap substrate 14 and the semiconductor substrate 12, it is provided at a predetermined position so as to enclose the periphery of the semiconductor device 11 without a break and not to cover the top of the semiconductor device 11. Thereby, the gap 13 around the semiconductor device 11 is hermetically sealed by the semiconductor substrate 12, the cap substrate 14, and the spacer 15. Materials used for the spacer 15 include, for example, varnish or paint, dry film or the like consisting of photosensitive or non-photosensitive resin (UV curing resin, visible-light curing resin, infrared-light curing resin, thermosetting resin, etc.).

As the material suited to constituting the spacer 15, a suitable selection should be made in accordance with the usage environment of the semiconductor package, but in particular a resin with excellent chemical resistance and thermal resistance, such as a polyimide or phenol resin, is suitable. In the case of a polyimide resin, by calcinating after forming the layer to cause a crosslinking reaction, it is possible to improve the chemical resistance and thermal resistance.

In the case of the material that constitutes the spacer 15 having photosensitivity, the photosensitive material includes a photosensitive resin such as epoxy acrylate and a photosensitive glass paste and the like.

When calcinating polyimide resin or glass paste, by forming the spacer 15 on the cap substrate 14 side and performing calcination of the spacer 15 prior to joining of the cap substrate 14 to the semiconductor substrate 12, it is possible to avoid damage of the semiconductor device 11 by the heat of the calcination.

Moreover, it is possible to hermetically seal the semiconductor package by making the spacer from a metal bond such as Sn or Au, glass, Si, and the like. Thereby, it is possible to prevent dew condensation in the gap 13.

In relation to the filter 16, the type of the filter 16 to be used is not limited, and a notch filter or ND filter, a band pass filter, and the like can be freely selected depending on the use of the semiconductor device 11. When using a CCD or a CMOS as the semiconductor device, it is preferable to use primary color filters that consist of red, green, and blue, complementary color filters that consist of cyan, magenta, yellow, and green, and an IR cut-off filter, etc.

In the present invention, the filter 16 is disposed on the surface 14a side of the cap substrate 14 at a position that overlaps the semiconductor device 11. This filter 16 may be directly disposed on the surface 14a side of the cap substrate 14, and may be disposed via an object which is disposed on the surface 14a side of the cap substrate 14. Also, since the position at which this filter 16 is arranged is a position that does not overlap with the dicing location and does not directly overlap with the spacer 15, it is possible to suppress exfoliation of the filter 16 via chipping during dicing. Also, since the spacer 15 is not bonded to the filter 16, it is possible to prevent exfoliation of the filter 16 arising from expansion and contraction of the spacer 15. Moreover, since the filter 16 is not disposed over the entire surface of the cap substrate 14, it is possible to relieve warping of the cap substrate 14 by the stress of the filter 16.

### Second Embodiment

As shown in FIG. 3, in the present invention, it is possible to arrange a filter 26 on an other surface 24b of a cap substrate 24. In this case as well, the filter 26 may be directly disposed on the other surface 24b of the cap substrate 24, or the filter 26 may be disposed via an object which is disposed on the other surface 24b of the cap substrate 24. Also, since the position at which this filter 26 is arranged does not overlap with the dicing location, it no longer becomes caught by the chipping during dicing. Moreover, since it is not in contact with a spacer 25, it is possible to avoid the exfoliation of the filter 26 due to the stress of expansion and contraction of the spacer 25 as conventionally seen. Since this filter 26 is provided on the outer peripheral portion of the semiconductor package 20, unnecessary light that directs the semiconductor device 21 can be blocked before entering the semiconductor package 20.

### Third Embodiment

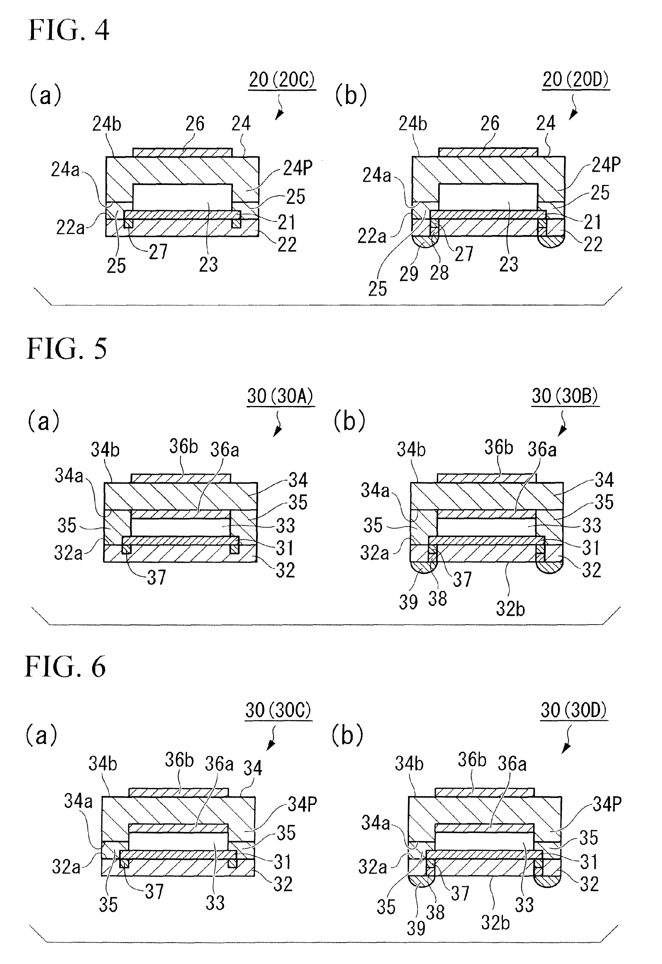

As shown in FIG. 5, in the present invention, it is possible to arrange a filter 36 on both one surface 34a and the other surface 34b of a cap substrate. That is, a semiconductor substrate 32, a first filter 36a, a cap substrate 34, and a second filter 36b are arranged in an overlapping manner in that order. In relation to the arrangement of the first filter 36a and the second filter 36b, they may be disposed directly on the cap substrate 34, and may be indirectly disposed via an object which is disposed on the cap substrate 34. In either case, since the first filter 36a and the second filter 36b are disposed at positions that do not overlap with the spacer 35 similarly to the two aforementioned embodiments, it is possible to prevent exfoliation of the filter due to chipping during dicing. Also, similarly to the aforementioned embodiments, since the spacer 35 is not directly bonded to both filters 36a and 36b, it is possible to prevent these filters 36 from exfoliating from stress due to expansion and contraction of the spacer 35. Moreover, in the case of disposing the filter 36 on both surfaces of the cap substrate 34, since stress of the filter 36 is applied to both surfaces of the cap substrate 34, it is possible to relieve warping of the cap substrate 34. In the case of an optical semiconductor device, by changing the combination of the first filter 36a and the second filter 36b, for example by changing the combination of an ND filter and a band pass filter, it is possible to manufacture an optical semiconductor package 30 corresponding to various situations.

In the semiconductor package of the present invention, Example 1 of the first embodiment is shown in (a) of FIG. 2, and is provided with a projecting portion 14P on the cap substrate 14. In the case of the spacer 15 consisting of resin, since the moisture permeability coefficient of resin is high, when the closure thickness of the resin is thick, there is a possibility of condensation forming in the gap 13. Also, if the distance from the semiconductor substrate 12 to the cap substrate 14 is short, optical problems related to such as imaging characteristics will arise. By equipping the cap substrate 14 with the projecting portion 14P in order to deal with both of these, thinning of the resin layer with a high moisture permeability coefficient is achieved and the condensation is suppressed, and by controlling the projecting portion 14P on the cap substrate 14, it is possible to adjust the distance from the semiconductor substrate 12 to the cap substrate 14. At this time, the height of the spacer 15 that joins the semiconductor substrate 12 and the projecting portion 14P on the cap substrate 14 is preferably 0.5 to 3 µm. Also, the distance from the semiconductor substrate 12 to the cap substrate 14 is preferably 10 to 100 µm.

As Example 2 of the second embodiment of the present invention, as shown in (a) of FIG. 4, a projecting portion 24P is provided on the cap substrate 24. With this constitution, the same effect as Example 1 is obtained.

As Example 3 of the third embodiment of the present invention, as shown in (a) of FIG. 6, a projecting portion 34P is provided on the cap substrate 34. With this constitution, it is possible to obtain the same effect as Example 1 and Example 2.

Also, in the semiconductor package of the present invention, as shown in (b) of FIG. 1, it is possible to provide a penetration electrode 18 and a solder bump 19. The penetration electrode 18 is provided from the other surface 12b side of the semiconductor substrate 12 toward the electrode 17, and the solder bump 19 is provided in electrical connection with this penetration electrode 18. Also, as shown in (b) of FIG. 3 and (b) of FIG. 5, it is possible to form the penetration electrodes 28, 38 and the solder bumps 29, 39 similarly in the second embodiment and the third embodiment.

In relation to the penetration electrode 18, an electrically conducting path is formed that enables the electrode 17 to conduct with the outside via the though electrode 18. The shape of the penetration electrode 18 is not particularly limited, but it is preferable to install it at a right angle to the semiconductor device 11. Also, as the material thereof, it is preferable to use metal, such as tin or copper. It is possible to form a back wiring layer on the other surface 12b of the semiconductor substrate 12 so as to make contact with this penetration electrode 18.

In relation to the solder bump 19, it is formed on the other surface 12b of the semiconductor substrate where the penetration electrode 18 is disposed, and installed so as to be in electrical contact with the penetration electrode 18. In relation to the material of the solder bump 19, the solder alloy that is used is not particularly limited, but in the case of using a lead-free solder alloy, it is preferable to use Sn Ag 3.0 Cu 0.5 or Sn Ag 3.5 Cu 0.7, and more preferable to use Sn Ag 3.0 Cu 0.5. Also, the size of the solder bump 19 and the pitch of forming the solder bump 19 are not particularly limited, but it is preferable for the size to be 30 to 250 µm and the pitch to be 100 to 400 µm.

By providing the penetration electrode 18 and the solder bump 19, compared to a conventional wire bonding, an improvement in the signal speed is achieved.

Also in the semiconductor package that is provided with the penetration electrode and the solder bump in the first embodiment of the present invention, as the Example 4, it is possible to use one that is similarly provided with a projecting portion 14P on the cap substrate. In the case of the spacer 15 being formed from resin, since the moisture permeability coefficient of resin is high, when the closure thickness of the resin is thick, there is a possibility of condensation forming in the gap 13. Also, if the distance from the semiconductor substrate 12 to the cap substrate 14 is short, optical problems related to such as imaging characteristics will arise. By providing the cap substrate 14 with the projecting portion 14P in order to deal with both of these, the resin layer with a high moisture permeability coefficient is thinned and the condensation is suppressed, and by controlling the projecting portion 14P on the cap substrate 14, it is possible to adjust the distance from the semiconductor substrate 12 to the cap substrate 14. At this time, the height of the spacer 15 that joins the semiconductor substrate 12 and the projecting portion 14P on the cap substrate 14 is preferably 0.5 to 3 µm. Also, the distance from the semiconductor substrate 12 to the cap substrate 14 is preferably 10 to 100 µm.

Also in the semiconductor package that provides the penetration electrode and the solder bump in the second embodiment of the present invention, there is an Example 5 in which the projecting portion 24P is installed on the cap substrate 24 as shown in (b) of FIG. 4. With this constitution, the same effect as Example 4 is obtained.

Also in the semiconductor package that provides the penetration electrode and the solder bump in the third embodiment of the present invention, there is an Example 6 in which the projecting portion 34P is installed on the cap substrate 34 as shown in (b) of FIG. 6. With this constitution, the same effect as Example 4 and Example 5 is obtained.

### (Method of Manufacture)

### First Embodiment

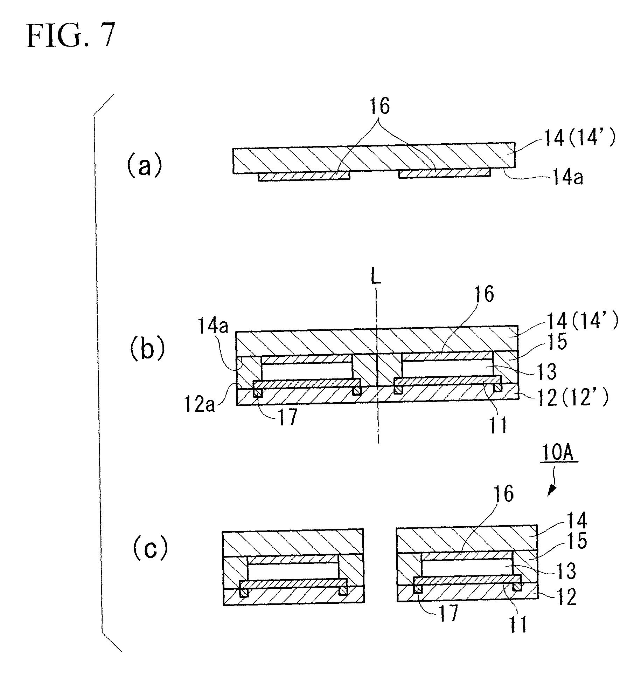

In the method of manufacturing the semiconductor package 10A of the first embodiment, first the filter 16 is formed on the surface 14a of the cap substrate 14 as shown in (a) of FIG. 7. (Here, the cap substrate 14 in (a) of FIG. 7 is an aggregate 14' of the cap substrate 14 of the semiconductor package 10A). As one example of this method of forming the filter 16 on the cap substrate 14, after forming a photosensitive resin on the surface 14a of the cap substrate 14 using a spin coater or the like, a pattern in accordance with the use condition is formed by technique of photolithography. As the material of the photosensitive resin, it is preferable to use a photopolymerization-type acrylic resin or one based on photo-crosslinkable polyvinyl alcohol. Also, when forming a color filter, it is possible to form it by an etching method with a polyimide precursor that is dispersed with a pigment serving as a colored resin layer. Also, there are some that consist of laminating TiO₂, SiO₂, MgF₂, Ta₂O₅ and the like by vapor deposition.

Next, as shown in (b) of FIG. 7, the spacer 15 is formed so as to be installed in a projecting manner on the cap substrate 14a, and the semiconductor substrate 12' on which the semiconductor device 11 and the electrode 17 are disposed is bonded. (Here, the semiconductor substrate 12 in (b) of FIG. 7 is an aggregate 12' of the semiconductor substrate 12 of the semiconductor package 10A). The cap substrate 14 is made to face the semiconductor substrate 12', and the spacer 15 that is formed on the surface 14a of the cap substrate 14 is bonded to the surface 12a of the semiconductor substrate 12. Thereby, the semiconductor substrate 12 and the cap substrate 14 are joined via the spacer 15. It is preferable to join them using an epoxy resin or a photosensitive BCB resin or the like.

Next, if the semiconductor substrate 12, the spacer 15, and the cap substrate 14 are divided by a dicing saw or the like along the cutting line L shown in (b) of FIG. 7 so that the spacer 15 is cut in two, the semiconductor package 10A of the present embodiment is obtained as shown in (c) of FIG. 7.

According to the manufacturing method of the semiconductor package 10A of the present invention, since the filter 16 is formed on a portion of the surface 14a of the cap substrate 14 without being formed on the entire surface thereof, it is possible to relieve warping of the cap substrate 14 by the stress of the filter 16. Also, the filter 16 is not installed on the dicing location L; it is possible to prevent exfoliation of the filter 16 by chipping due to dicing. Furthermore, since the filter 16 is not caught by the spacer 15 and the cap substrate 14, it is possible to also prevent the filter 16 from exfoliating by the stress arising from the expansion and contraction of the spacer 15. Also, since the filter 16 is formed inside of the semiconductor package 10A, the filter 16 is protected during the processing of the semiconductor package 10A.

### Second Embodiment

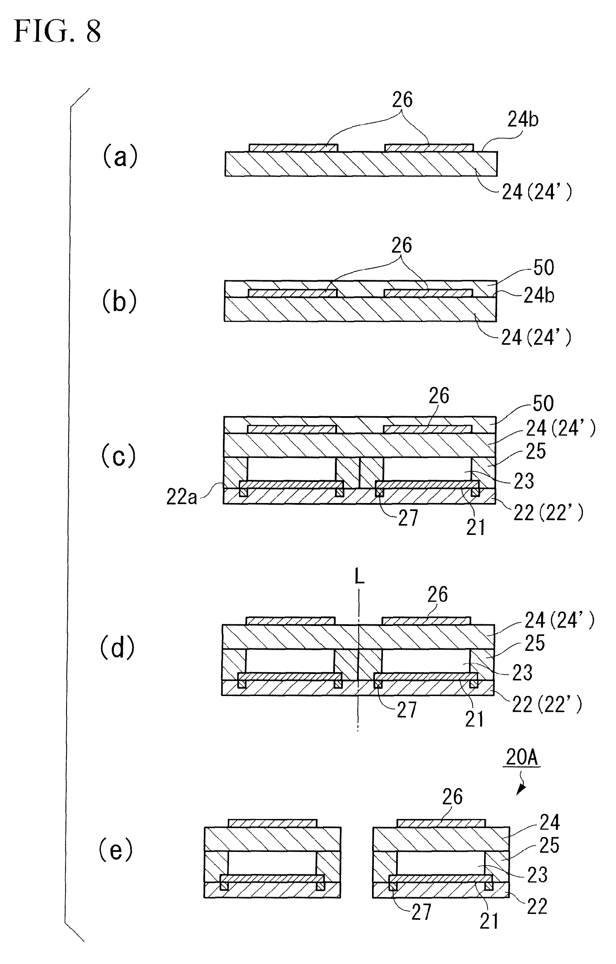

Next, FIG. 8 is a cross-sectional process drawing that describes the method of manufacturing the semiconductor package 20A according to the second embodiment of the present invention.

In the second embodiment of the present invention, explanations that overlap with the first embodiment shall be omitted.

In the manufacturing method in the second embodiment, first the filter 26 is formed on the other surface 24b of the cap substrate 24, as shown in (a) of FIG. 8. (Here, the cap substrate 24 in (a) of FIG. 8 is an aggregate 24' of the cap substrate 24 of the semiconductor package 20A). The method of forming the filter 26 is the same as that of the first embodiment.

Next, as shown in (b) of FIG. 8, a protective film 50 is formed so as to cover the filter 26. In relation to this protective film 50, it is preferably one that can be removed in a subsequent step, and is preferably one that uses a resin that can be removed or a fine adhesion film. In relation to the method of forming this protective film 50, a laminate of film, a spin coat of resin that can be removed, or the like, is used.

Next, similarly to (b) of FIG. 7 of the first embodiment, the cap substrate 24, the spacer 25, and the semiconductor substrate 22 are joined as shown in (c) of FIG. 8. (Here, the semiconductor substrate 22 in (c) of FIG. 8 is an aggregate 22' of the semiconductor substrate 22 of the semiconductor package 20A).

Next, as shown in (d) of FIG. 8, the protective film 50 that was formed in (b) of FIG. 8 is removed. In relation to the removal of the protective film 50, a chemical (or in the case of film a separator) is used so as not to damage the filter 26. Also, it is preferable to remove the protective film 50 by performing a dry process such as O₂ ashing.

Next, if the semiconductor substrate 22, the spacer 25, and the cap substrate 24 are divided along the cutting line L shown in (d) of FIG. 8, the semiconductor package 20A of the present embodiment is obtained as shown in (e) of FIG. 8.

According to the manufacturing method of the semiconductor package 20A of the second embodiment of the present invention, it is possible to prevent exfoliation of the filter 26 by the same reason as the first embodiment. Also, since the filter 26 that is formed on the other surface 24b of the cap substrate 24 is covered by the protective film 50 after formation of the filter 26, it is possible to prevent damage to the filter 26 during the manufacturing process.

### Third Embodiment

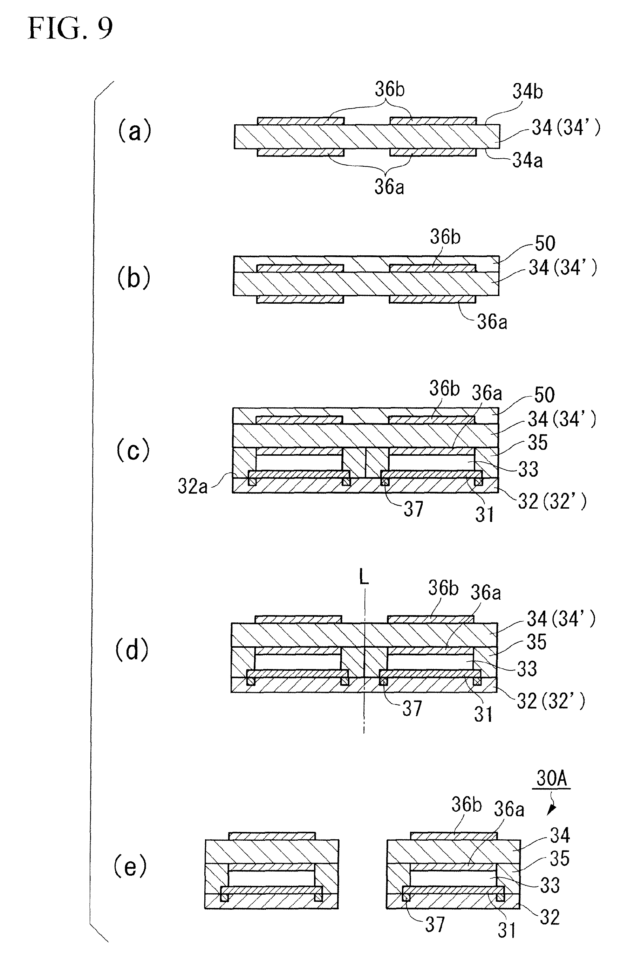

Next, FIG. 9 is a cross-sectional process drawing that describes the method of manufacturing the semiconductor package 30A according to the third embodiment. In the third embodiment of the present invention, explanations that overlap with the first embodiment and the second embodiment shall be omitted.

In the method of manufacture in the third embodiment, first the first filter 36a and the second filter 36b are formed on the surface 34a of the cap substrate 34 and the other surface 34b of the cap substrate 34, respectively, as shown in (a) of FIG. 9. (Here, the cap substrate 34 in (a) of FIG. 9 is an aggregate 34' of the cap substrate 34 of the semiconductor package 30A). The method of forming the first filter 36a and the second filter 36b is the same as that of the first embodiment and the second embodiment.

Next, as shown in (b) of FIG. 9, the second filter 36b is covered with a protective film 50. In relation to the method of forming the protective film 50, it is the same as the case of the second embodiment.

Next, similarly to (b) of FIG. 7 of the first embodiment, the cap substrate 34, the spacer 35, and the semiconductor substrate 32 are joined as shown in (c) of FIG. 9. (Here, the semiconductor substrate 32 in (c) of FIG. 9 is an aggregate 32' of the semiconductor substrate 32 of the semiconductor package 30A).

Next, as shown in (d) of FIG. 9, the protective film 50 that was formed in (b) of FIG. 9 is removed. This step is the same as the method shown in (d) of FIG. 8 of the second embodiment.

Finally, if the semiconductor substrate 32, the spacer 35, and the cap substrate 34 are divided along the cutting line L shown in (d) of FIG. 9, the semiconductor package 30A of the present embodiment is obtained as shown in (e) of FIG. 9.

In the third embodiment as well, it is possible to prevent exfoliation of the first filter 36a and the second filter 36b for the same reason as the first embodiment and the second embodiment. Also, in relation to the first filter 36a, since the filter is formed in the semiconductor package 30, and also in relation to the second filter 36b since it is provided with a step of covering with a protective film similarly to the second embodiment, it is possible to prevent damage to both filters during the manufacturing process.

Method of manufacturing a semiconductor package in which penetration electrodes and soldier bumps are formed

### First Embodiment

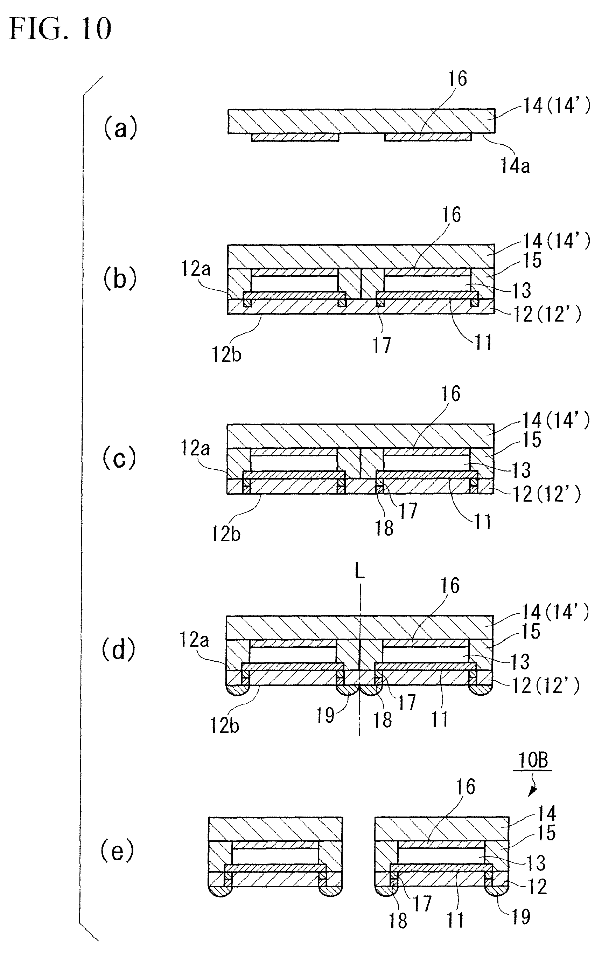

In the method of manufacturing the semiconductor package 10B of the first embodiment that is provided with penetration electrodes and solder bumps, first the filter 16 is formed on the surface 14a of the cap substrate 14 as shown in (a) of FIG. 10. (Here, the cap substrate 14 in (a) of FIG. 10 is an aggregate 14' of the cap substrate 14 of the semiconductor package 10B). As one example of this method of forming the filter 16 on the cap substrate 14, after forming a photosensitive resin on the surface 14a of the cap substrate 14 using a spin coater or the like, a pattern in accordance with the use condition is formed by technique of photolithography. As the material of the photosensitive resin, it is preferable to use a photopolymerization-type acrylic resin or one based on photo-crosslinkable polyvinyl alcohol. Also, when forming a color filter, it is possible to form it by an etching method with a polyimide precursor that is dispersed with a pigment serving as a colored resin layer.

Next, as shown in (b) of FIG. 10, the spacer 15 is formed so as to be installed in a projecting manner on the cap substrate 14a, and the semiconductor substrate 12 on which the semiconductor device 11 and the electrode 17 are disposed is bonded. (Here, the semiconductor substrate 12 in (b) of FIG. 10 is an aggregate 12' of the semiconductor substrate 12 of the semiconductor package 10B).

The cap substrate 14 is made to face the semiconductor substrate 12, and the spacer 15 that is formed on the surface 14a of the cap substrate 14 is bonded to the surface 12a of the semiconductor substrate 12. Thereby, the semiconductor substrate 12 and the cap substrate 14 are joined via the spacer 15. It is preferable to join them using an epoxy resin or a photosensitive BCB resin or the like.

Next, as shown in (c) of FIG. 10, through holes are formed from the other surface 12b of the semiconductor substrate 12 toward the electrode 17. In relation to the formation of the through holes, it is preferable to use a silicon deep etching apparatus (DeepRIE). An SiO₂ layer is formed in each through hole as an oxide film layer using plasma-enhanced chemical vapor deposition to form an insulative layer in each through hole. Next, using reactive ion etching, the SiO₂ layer of the hole bottom portion is selectively removed. Thereafter, a seed layer is formed by sputtering, and the penetration electrode 18 and, although not shown in the drawing, where necessary a back wiring layer are formed by electrolytic plating.

Next, as shown in (d) of FIG. 10, the solder bumps 19 are formed so as to be electrically connected to the penetration electrodes 18. In relation to the formation of the solder bumps 19, it is preferable to perform a HASL process, OSP process, electroless Ni-immersion Au process, or immersion Ag process, or the like, according to necessity. Also, although not shown in the drawing, in the case of manufacturing a back wiring layer, the solder bumps 19 are manufactured so as to be electrically connected to the back wiring layer.

Next, if the semiconductor substrate 12 and the cap substrate 14 are divided along the cutting line L shown in (d) of FIG. 10 so that the spacer 15 is cut in two, the semiconductor package 10B that is provided with the penetration electrodes 18 and the solder bumps 19 is obtained as shown in (e) of FIG. 10.

According to the manufacturing method of the semiconductor package 10B of the present invention, since the filter 16 is not installed on the dicing location L, it is possible to prevent exfoliation of the filter 16 by chipping due to dicing. Furthermore, since the filter 16 is formed on a portion of the surface 14a of the cap substrate 14 without being formed on the entire surface thereof, it is possible to relieve warping of the cap substrate 14 by the stress of the filter 16. Furthermore, since the filter 16 is not caught by the spacer 15 and the cap substrate 14, it is possible to also prevent the filter 16 from exfoliating by the stress arising from the expansion and contraction of the spacer 15. In addition, since the filter 16 is formed inside of the semiconductor package 10B, the filter 16 is protected during the processing of the semiconductor package 10B. In relation to the penetration electrode 18, since the opening location is not disposed on the dicing location, it is possible to prevent entry of particles or the like and deformation and the like due to dicing.

### Second Embodiment

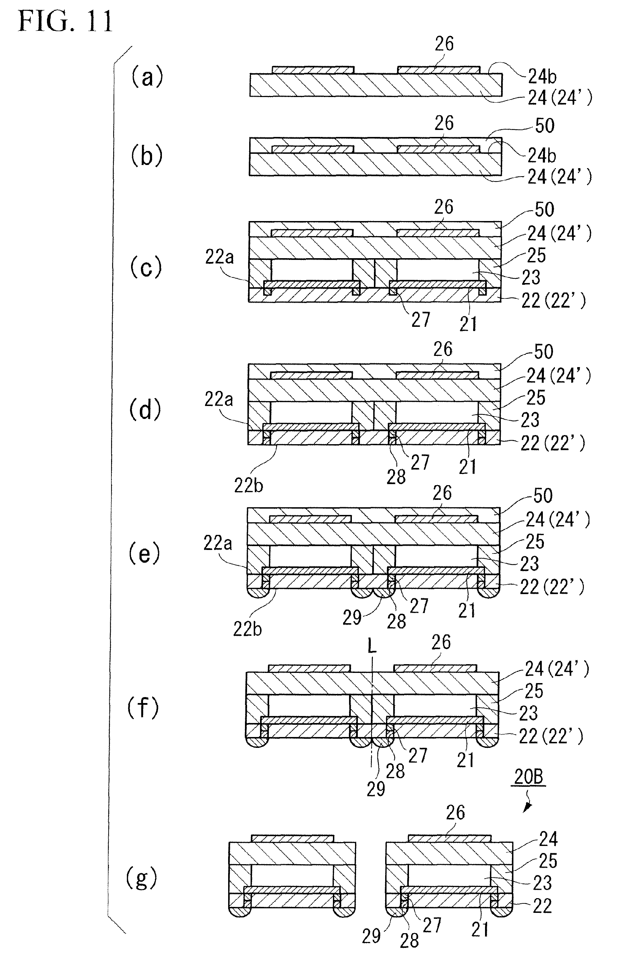

Next, FIG. 11 is a cross-sectional process drawing that describes the method of manufacturing the semiconductor package 20B that is provided with the penetration electrode 28 and the solder bump 29 in the second embodiment of the present invention.

In the second embodiment of the present invention that is provided with the penetration electrode 28 and the solder bump 29, descriptions that overlap with the manufacturing process of FIG. 10 shall be omitted.

In the manufacturing method in the present embodiment, first the filter 26 is formed on the other surface 24b of the cap substrate 24 as shown in (a) of FIG. 11. The method of forming the filter 26 is the same as (a) of FIG. 10. (Here, the cap substrate 24 in (a) of FIG. 11 is an aggregate 24' of the cap substrate 24 of the semiconductor package 20B).

Next, as shown in (b) of FIG. 11, a protective film 50 is formed so as to cover the filter 26.

In relation to this protective film 50, it is preferably one that can be removed in a subsequent step, and is preferably one that uses a resin that can be removed or a fine adhesion film. In relation to the method of forming this protective film 50, a spin coat of resin that can be removed, or a laminate of dry film (fine adhesion film or the like) is used.

Next, similarly to (b) of FIG. 10, the cap substrate 24, the spacer 25, and the semiconductor substrate 22 are joined as shown in (c) of FIG. 11. (Here, the semiconductor substrate 22 in (c) of FIG. 11 is an aggregate 22' of the semiconductor substrate 22 of the semiconductor package 20B).

Next, as shown in (d) of FIG. 11, the penetration electrode 28 is formed from the other surface 22b of the semiconductor substrate 22 toward the electrode 27. In relation to the formation of the penetration electrode 28, it is the same as (c) of FIG. 10.

Next, as shown in (e) of FIG. 11, the solder bump 29 is formed similarly to (d) of FIG. 10 so as to be electrically connected to the penetration electrode 28.

Next, as shown in (f) of FIG. 11, the protective film 50 that was formed in (b) of FIG. 11 is removed. In relation to the removal of the protective film 50, a chemical or dry process is used so as not to impart damage to the filter 26. Also, in relation to the chemical, it is preferable to remove the protective film 50 that is formed so as to cover the filter 26 using an organic solvent such as acetone that does not cause damage to the filter. In the dry process, it is preferable to use O₂ ashing.

Next, if the semiconductor substrate 22, the spacer 25, and the cap substrate 24 are divided along the cutting line L shown in (f) of FIG. 11, the semiconductor package 20B of the present embodiment is obtained as shown in (g) of FIG. 11

According to the manufacturing method of the present embodiment, it is possible to prevent exfoliation of the filter 26 by the same reason as the first embodiment of FIG. 10 provided with the penetration electrodes 28 and the solder bumps 29. Also, since the filter 26 that is formed on the other surface 24b of the cap substrate 24 is covered by the protective film 50 after formation of the filter 26, it is possible to prevent damage to the filter 26 during the manufacturing process. Also, in relation to the penetration electrodes 28, since the opening location is not disposed at the dicing location, it is possible to prevent entry of particles or the like and deformation or the like due to dicing.

### Third Embodiment

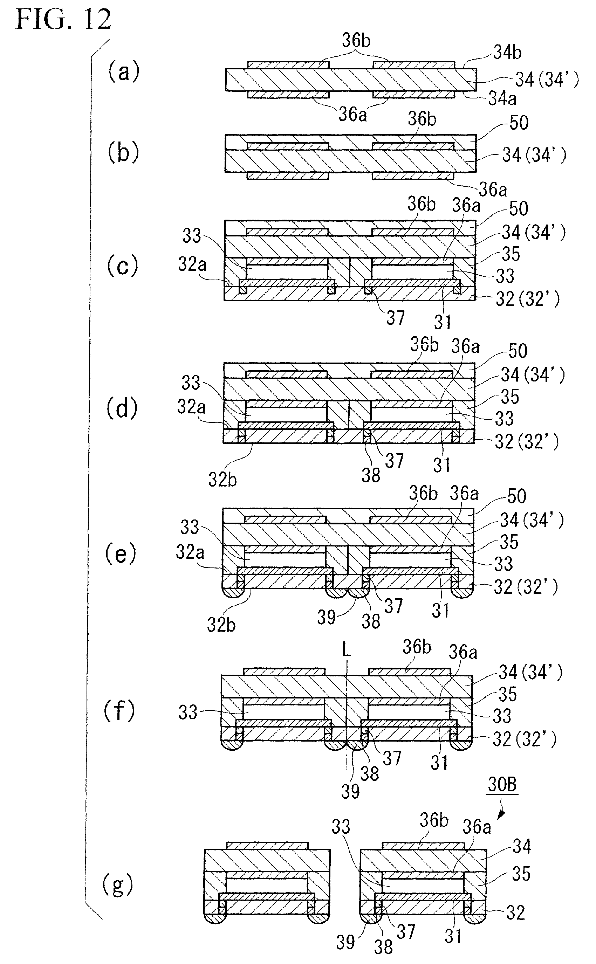

Next, FIG. 12 is a cross-sectional process drawing that describes the method of manufacturing the semiconductor package 30B according to the third embodiment that is provided with the penetration electrodes and the solder bumps.

In the method of manufacture in the third embodiment, first the first filter 36a and the second filter 36b are formed on the surface 34a of the cap substrate 34 and the other surface 34b of the cap substrate 34, respectively, as shown in (a) of FIG. 12. (Here, the cap substrate 34 in (a) of FIG. 12 is an aggregate 34' of the cap substrate 34 of the semiconductor package 30B). The method of forming the first filter 36a and the second filter 36b is the same as the manufacturing process of FIG. 10.

Next, as shown in (b) of FIG. 12, the second filter 36b is covered with a protective film 50. In relation to the method of forming the protective film 50, it is the same as the manufacturing process of (b) of FIG. 11.

Next, similarly to (b) of FIG. 10, the cap substrate 34, the spacer 35, and the semiconductor substrate 32 are joined as shown in (c) of FIG. 12. (Here, the semiconductor substrate 32 in (c) of FIG. 12 is an aggregate 32' of the semiconductor substrate 32 of the semiconductor package 30B).

Next, as shown in (d) of FIG. 12, the penetration electrode 38 is formed from the other surface 32b of the semiconductor substrate 32 toward the electrode 37. In relation to the formation of the penetration electrode 38, it is the same as (c) of FIG. 10.

Next, as shown in (e) of FIG. 12, the solder bump 39 is formed similarly to (d) of FIG. 10 so as to be electrically connected to the penetration electrode 38.

Next, as shown in (f) of FIG. 12, the protective film 50 that was formed in (b) of FIG. 12 is removed. This step is the same as (f) of FIG. 11.

Next, if the semiconductor substrate 32, the spacer 35, and the cap substrate 34 are divided along the cutting line L shown in (f) of FIG. 12, the semiconductor package 30B of the present embodiment is obtained as shown in (g) of FIG. 12.

In the present embodiment, it is possible to prevent exfoliation of the first filter 36a and the second filter 36b by the same reason as the manufacturing steps of FIG. 11 and FIG. 12. Also, in relation to the first filter 36a, since the filter is formed in the semiconductor package 30B, and also in relation to the second filter 36b since it is provided with a step of covering with the protective film 50 similarly to the second embodiment, it is possible to prevent damage to both filters during the manufacturing process. Also, in relation to the penetration electrode 38, since the opening location is not disposed on the dicing location, it is possible to prevent entry of particles or the like and deformation or the like due to dicing.

Also, in the manufacturing process of the first embodiment, one that is provided with the projecting portion 14P on the cap substrate 14 as shown in Examples 1 and 4 may be used. In the case of the spacer 15 being formed from resin, since the moisture permeability coefficient of resin is high, when the closure thickness of the resin is thick, there is a possibility of condensation forming in the gap 13. Also, if the distance from the semiconductor substrate 12 to the cap substrate 14 is short, optical problems related to such as imaging characteristics will arise. By providing the cap substrate 14 with the projecting portion 14P in order to deal with both of these, thinning of the resin layer with a high moisture permeability coefficient is achieved and the condensation is suppressed, and by controlling the projecting portion 14P on the cap substrate 14, it is possible to adjust the distance from the semiconductor substrate 12 to the cap substrate 14. At this time, the height of the spacer 15 that joins the semiconductor substrate 12 and the projecting portion 14P on the cap substrate 14 is preferably 0.5 to 3 µm. Also, the distance from the semiconductor substrate 12 to the cap substrate 14 is preferably 10 to 100 µm.

Also, by similarly providing the projecting portion on the cap substrate in the manufacturing process of the second embodiment and the manufacturing process of the third embodiment, it is possible to achieve the same effects as above.

Furthermore, it is the same even in each manufacturing step of a semiconductor device that is provided with penetration electrodes and soldering bumps.

### INDUSTRIAL APPLICABILITY

The present invention is particularly useful in the case of disposing a filter on a cap substrate in packaging on a wafer level of a semiconductor device that is formed on a semiconductor substrate.

## Claims

1. A semiconductor package comprising:
a semiconductor device;
a semiconductor substrate having the semiconductor device arranged on one surface;
a cap substrate having one surface that opposes the one surface of the semiconductor substrate via a gap;
a spacer that is arranged between the one surface of the semiconductor substrate and the one surface of the cap substrate, and that joins the semiconductor substrate and the cap substrate; and
a filter that is provided on the cap substrate so as to overlap with the semiconductor device without overlapping with the spacer.

2. The semiconductor package according to claim 1, wherein the filter is disposed overlapping in the order of the semiconductor substrate, the filter, and the cap substrate.

3. The semiconductor package according to claim 1, wherein the filter is disposed overlapping in the order of the semiconductor substrate, the cap substrate, and the filter.

4. The semiconductor package according to claim 1, wherein the filter includes a first filter and a second filter, and are disposed overlapping in the order of the semiconductor substrate, the first filter, the cap substrate, and the second filter.

5. The semiconductor package according to claim 1, provided with:
an electrode that is on the one surface side of the semiconductor substrate and in electrical contact with the semiconductor device;
a penetration electrode that is provided from the other surface side of the semiconductor substrate toward the electrode; and a solder bump that is electrically connected with the penetration electrode.

6. A method of manufacturing a semiconductor package provided with a semiconductor device; a semiconductor substrate having the semiconductor device arranged on one surface; a cap substrate having one surface that opposes the one surface of the semiconductor substrate via a gap; a spacer that is arranged between the one surface of the semiconductor substrate and the one surface of the cap substrate, and that joins the semiconductor substrate and the cap substrate; and a filter that is provided on the cap substrate so as to overlap with the semiconductor device without overlapping with the spacer,
the method provided with a first step that forms a plurality of the filters on the cap substrate; a second step that bonds the semiconductor substrate on one surface of which a plurality of the semiconductor devices are disposed so as to mutually sandwich a dividing portion and the cap substrate on which the plurality of filters are arranged via the spacer at the separating portion; and a third step that divides a structure that consists of the cap substrate, the plurality of semiconductor devices, the semiconductor substrate, and the spacer at an area where the spacer is in the direction in which the semiconductor substrate and the cap substrate overlap.

7. The method of manufacturing a semiconductor package according to claim 6 provided with, after the second step, a step that forms a penetration electrode to be electrically connected from the other surface side of the semiconductor substrate toward the semiconductor device and a step that forms a solder bump that is electrically connected with the penetration electrode.
